(19) **Europäisches Patentamt / European Patent Office / Office européen des brevets**

(11) **EP 3 440 472 B1**

(12) **FASCICULE DE BREVET EUROPEEN**

(45) Date de publication et mention
de la délivrance du brevet:
**20.07.2022   Bulletin 2022/29**

(21) Numéro de dépôt: **17713306.3**

(22) Date de dépôt: **28.03.2017**

(51) Classification Internationale des Brevets (IPC):
**G01R 31/11** *(2006.01)*

(52) Classification Coopérative des Brevets (CPC):
**G01R 31/11**

(86) Numéro de dépôt international:
**PCT/EP2017/057296**

(87) Numéro de publication internationale:
**WO 2017/174400 (12.10.2017 Gazette 2017/41)**

(54) **PROCEDE DE DETECTION DE DEFAUTS NON FRANCS DANS UN CABLE PAR FUSION DE DONNEES**

VERFAHREN ZUR ERKENNUNG VON WEICHEN FEHLERN IN EINEM KABEL DURCH DATENFUSION

METHOD FOR DETECTING SOFT FAULTS IN A CABLE BY DATA FUSION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **08.04.2016   FR 1653095**

(43) Date de publication de la demande:
**13.02.2019   Bulletin 2019/07**

(73) Titulaire: **Commissariat à l'Énergie Atomique et aux Énergies Alternatives
75015 Paris (FR)**

(72) Inventeurs:
• **BEN HASSEN, Wafa
75014 PARIS (FR)**
• **MOTTIN, Julien
38054 GRENOBLE Cedex 9 (FR)**
• **DUPRET, Antoine
91400 ORSAY (FR)**

• **GALLEGO ROMAN, Miguel
75014 PARIS (FR)**
• **LESECQ, Suzanne
38190 FROGES (FR)**
• **PUSCHINI PASCUAL, Diego
38054 GRENOBLE Cedex 9 (FR)**
• **RAVOT, Nicolas
77500 CHELLES (FR)**
• **ZANCHETTA, Armando
74890 BONS-ENCHABLAIS (FR)**

(74) Mandataire: **Marks & Clerk France
Immeuble "Visium"
22, avenue Aristide Briand
94117 Arcueil Cedex (FR)**

(56) Documents cités:
**FR-A1- 2 981 752          GB-A- 2 496 121
US-A1- 2005 057 880**

EP 3 440 472 B1

**Description**

L'invention concerne le domaine des systèmes de diagnostic filaires basés sur le principe de la réflectométrie. Elle a pour objet un procédé de détection de défauts non francs dans un câble utilisant une méthode de fusion de données afin de produire un diagnostic unique à partir des résultats produits par plusieurs méthodes de détection de défauts indépendantes entre elles.

Les câbles sont omniprésents dans tous les systèmes électriques, pour l'alimentation ou la transmission d'information. Ces câbles sont soumis aux mêmes contraintes que les systèmes qu'ils relient et peuvent être sujets à des défaillances. Il est donc nécessaire de pouvoir analyser leur état et d'apporter des informations sur la détection de défauts, mais aussi leur localisation et leur type, afin d'aider à la maintenance. Les méthodes de réflectométrie usuelles permettent ce type de tests.

Les méthodes de réflectométrie utilisent un principe proche de celui du radar : un signal électrique, le signal de sonde ou signal de référence, qui est le plus souvent de haute fréquence ou large bande, est injecté en un ou plusieurs endroits du câble à tester. Le signal se propage dans le câble ou le réseau et renvoie une partie de son énergie lorsqu'il rencontre une discontinuité électrique. Une discontinuité électrique peut résulter, par exemple, d'un branchement, de la fin du câble ou d'un défaut ou plus généralement d'une rupture des conditions de propagation du signal dans le câble. Elle résulte le plus souvent d'un défaut qui modifie localement l'impédance caractéristique du câble en provoquant une discontinuité dans ses paramètres linéiques.

L'analyse des signaux renvoyés au point d'injection permet d'en déduire des informations sur la présence et la localisation de ces discontinuités, donc des défauts éventuels. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ».

L'invention entre dans le champ d'application des méthodes de réflectométrie pour le diagnostic filaire et s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées ou autre pourvu qu'il soit possible d'y injecter un signal de réflectométrie en un point du câble et de mesurer sa réflexion au même point ou en un autre point.

Un problème à résoudre pour la mise en œuvre d'une méthode de détection de défauts par réflectométrie est la limitation, voire l'annulation, des fausses détections encore appelées « faux positifs ».

Un point commun à de nombreuses méthodes de détection de défauts est l'application d'un post-traitement particulier au réflectogramme temporel mesuré afin d'amplifier ou d'isoler la signature d'un défaut, en particulier un défaut non franc. La recherche de la signature du défaut dans le réflectogramme post-traité conduit parfois à détecter des signatures qui ne correspondent pas à un défaut mais à un artefact de mesure, à l'influence du bruit ou à d'autres inhomogénéités présentes dans le câble.

Un objectif de la présente invention est de proposer une méthode de détection de défauts, applicable aux défauts non francs, qui engendre un taux de fausses détections diminué par rapport aux méthodes connues.

Les méthodes de réflectométrie TDR et FDR ainsi que les méthodes dérivées de ces dernières telles que la méthode MCTDR (Multi-Carrier Time Domain Reflectometry) ou OMTDR (Orthogonal Multi-tone Time Domain Reflectometry) ont prouvé leur efficacité dans la détection et la localisation de défauts francs, c'est-à-dire des défauts qui impactent significativement l'impédance caractéristique locale d'un câble, par exemple des défauts associés à une détérioration du matériau diélectrique constituant le câble.

Au contraire, lorsqu'il s'agit de détecter et localiser la présence de défauts non francs, c'est-à-dire des défauts superficiels, ces méthodes sont relativement limitées. Cette difficulté est due au fait qu'un défaut non franc se traduit par une très faible variation d'impédance caractéristique et un coefficient de réflexion également très faible. Par conséquent, un signal se réfléchissant sur un tel défaut non franc engendrera une réflexion d'amplitude très faible par rapport à l'amplitude d'une réflexion identique sur un défaut franc. Le pic d'amplitude, encore appelé signature, du défaut non franc peut donc être noyé dans le bruit de mesure ou masqué par un défaut franc adjacent.

Un défaut non franc introduit généralement une modification locale des caractéristiques électriques d'une ligne de transmission, par exemple d'un câble. La dégradation physique, même superficielle, de la ligne entraine en particulier une modification locale de l'impédance caractéristique du câble, ce qui entraine une modification du coefficient de réflexion à l'endroit du défaut.

Le terme défaut non franc vise ici tout défaut impactant superficiellement un câble de sorte à engendrer une variation de l'impédance caractéristique localement. En particulier, de tels défauts incluent une éraflure ou une usure de la gaine, du diélectrique mais aussi le début de la dégradation du conducteur métallique, la compression d'un câble, le frottement ou encore la corrosion. Ces dégradations peuvent, au premier abord, sembler bénignes et sans répercussions notables pour le système. Cependant, si rien n'est fait, les contraintes mécaniques, environnementales ou encore le vieillissement du câble, feront évoluer un défaut non franc vers un défaut franc, dont les conséquences, tant économiques que matérielles, peuvent être considérables. Détecter les défauts naissants permet une meilleure gestion de la maintenance et donc une réduction des coûts de réparation.

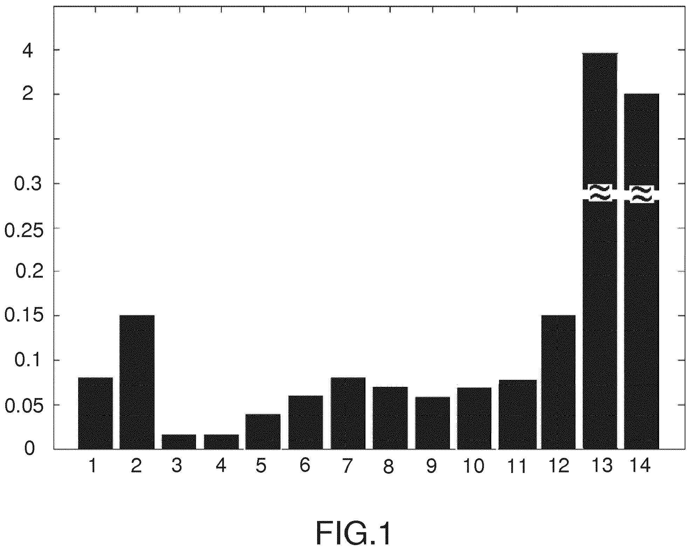

La figure 1 représente sur un histogramme, un exemple de valeurs moyennes de l'amplitude de la signature d'un défaut dans un réflectogramme, en fonction du type de défaut. Les types de défauts sont indicés de 1 à 14 et concernent :

- 1 : un défaut du au bruit des équipements de mesure,
- 2 : un défaut du au bruit généré par le mouvement du câble,
- 3 : une coupure du haut de la gaine du câble de l'ordre de 0.15mm,
- 4 : une coupure du haut de la gaine du câble de l'ordre de 0.45mm,
- 5 : une coupure du haut de la gaine du câble de l'ordre de 0.75mm,
- 6 : une coupure du côté de la gaine du câble de l'ordre de 0.15mm,
- 7 : une coupure du côté de la gaine du câble de l'ordre de 0.45mm,
- 8 : une coupure du côté de la gaine du câble de l'ordre de 0.75mm,
- 9 : un arrachement de l'isolant du câble,
- 10 : un défaut du à l'humidité,
- 11 : un défaut impactant le conducteur du câble,
- 12 : un défaut du à l'humidité sur une section du câble où l'isolant a été arraché,
- 13 : un circuit ouvert,
- 14 : un court-circuit.

Les défauts 3 à 11 sont considérés comme des défauts non francs. La liste donnée ci-dessus à l'appui de la figure 1 est illustrative et non limitative, un défaut non franc pouvant résulter d'autres dégradations non indiquées ci-dessus. On comprend que la caractérisation d'un défaut non franc dépend de l'amplitude du signal réfléchi sur la discontinuité d'impédance engendrée par ce défaut.

On connait plusieurs méthodes de détection et/ou localisation de défauts particulièrement adaptées aux défauts non francs. On peut citer notamment les demandes de brevet français déposées par le Demandeur sous les numéros FR1159481, FR1355377, FR1459402, FR1554632, FR1651702, ainsi que les méthodes décrites dans les publications scientifiques référencées [1] et [2].

Un point commun de toutes ces méthodes est que, bien qu'elles permettent d'améliorer la détection et la localisation de défauts non francs, elles présentent toutes l'inconvénient de générer également de fausses détection sur des artefacts du réflectogramme temporel qui ne correspondent pas à des défauts mais à du bruit de mesure ou des inhomogénéités du câble. Cet inconvénient est notamment dû au fait que ces méthodes visent généralement à amplifier la signature d'un défaut non franc sur un réflectogramme mais elles entrainent aussi l'amplification d'autres inhomogénéités. Cet inconvénient a pour conséquence une ambiguïté dans la détection et la localisation des défauts non francs.

On connait par ailleurs les méthodes décrites dans les documents GB2496121, FR 2981752 et US 2005/057880.

Un objectif de l'invention est de diminuer le taux de fausses détection par rapport aux méthodes de l'art antérieur en tirant parti de la diversité des méthodes existantes qui sont indépendantes entre elles pour appliquer un processus de fusion de données permettant d'obtenir un diagnostic unifié à partir des résultats fournis par plusieurs méthodes indépendantes.

L'invention a ainsi pour objet un procédé de détection de défauts non francs dans une ligne de transmission comprenant les étapes suivantes :

- Acquérir une mesure, appelée réflectogramme temporel, d'un signal caractéristique de la réflexion d'un signal de référence préalablement injecté dans la ligne,
- Déterminer la différence entre ledit réflectogramme temporel et un réflectogramme temporel mesuré antérieurement pour la même ligne ou une autre ligne de caractéristiques similaires, afin d'obtenir un réflectogramme temporel corrigé,

- Appliquer une pluralité de transformations indépendantes au réflectogramme temporel corrigé afin d'obtenir une pluralité de réflectogrammes transformés indépendants,
- Convertir les réflectogrammes transformés en une pluralité de probabilités d'occurrence d'un défaut indépendantes entre elles,
- Appliquer une méthode de fusion de données aux probabilités d'occurrence d'un défaut pour en déduire une valeur unifiée de la probabilité d'occurrence d'un défaut.

Selon un mode de réalisation particulier de l'invention, la conversion de chaque réflectogramme transformé en une mesure de la probabilité d'occurrence d'un défaut comprend les étapes suivantes :

- Normaliser en amplitude chaque réflectogramme transformé,
- Définir une pluralité de seuils de détection et pour chaque réflectogramme normalisé, construire un signal représentant le pourcentage de seuils de détection dépassés par chaque échantillon,
- Discrétiser temporellement chaque signal,
- Convertir chaque signal discrétisé en une probabilité d'occurrence d'un défaut.

Selon un mode de réalisation particulier de l'invention, la normalisation en amplitude de chaque réflectogramme transformé est une normalisation par le maximum de la valeur absolue des échantillons du réflectogramme transformé.

Selon un mode de réalisation particulier de l'invention, les seuils de détection sont définis en choisissant un seuil initial $s_0$ de valeur au moins supérieure à un niveau de bruit moyen et chaque seuil successif égal au seuil précédent incrémenté d'un pas constant.

Selon un mode de réalisation particulier de l'invention, la discrétisation temporelle de chaque signal comprend :

- la partition temporelle du signal en une pluralité d'intervalles temporels et,
- pour chaque intervalle temporel, la somme des nombres de seuils normalisés comptabilisés pour chaque échantillon appartenant audit intervalle temporel.

Selon un mode de réalisation particulier de l'invention, la conversion de chaque signal discrétisé en une probabilité d'occurrence d'un défaut comprend l'application, à chaque signal discrétisé, d'une fonction de conversion affine.

Selon un mode de réalisation particulier de l'invention, la méthode de fusion de données appliquée comprend

- Le regroupement des probabilités d'occurrence d'un défaut par couples,
- Une première application d'une fonction de fusion de données à chaque couple de probabilités,
- Une application itérative de la fonction de fusion de données aux résultats de la première application jusqu'à obtenir une unique valeur unifiée de probabilité d'occurrence d'un défaut.

Selon une variante de réalisation, le procédé selon l'invention comprend en outre une étape de diagnostic comprenant la comparaison de la valeur unifiée de probabilité d'occurrence d'un défaut à un seuil de détection.

Selon un mode de réalisation particulier de l'invention, l'acquisition d'un réflectogramme temporel comprend la corrélation de la mesure du signal caractéristique de la réflexion d'un signal de référence préalablement injecté dans la ligne et dudit signal de référence.

L'invention a aussi pour objet un programme d'ordinateur comportant des instructions pour l'exécution du procédé de détection de défauts non francs dans un câble selon l'invention, lorsque le programme est exécuté par un processeur ainsi qu'un support d'enregistrement lisible par un processeur sur lequel est enregistré un programme comportant des instructions pour l'exécution du procédé de détection de défauts non francs dans un câble selon l'invention, lorsque le programme est exécuté par un processeur.

D'autres caractéristiques et avantages de la présente invention apparaîtront mieux à la lecture de la description qui suit en relation aux dessins annexés qui représentent :

- La figure 1, un histogramme illustrant l'amplitude de la signature d'un défaut dans un réflectogramme, en fonction du type de défaut,
- La figure 2, un schéma illustrant le principe connu de la réflectométrie temporelle et son application à la détection d'un défaut non franc,
- La figure 3, un exemple de réflectogramme illustrant l'allure de la signature d'un défaut non franc,
- La figure 4, un organigramme détaillant les étapes du procédé selon l'invention,
- La figure 5, un exemple de résultat de mesure de la probabilité d'apparition d'un défaut dans un câble obtenu par le procédé selon l'invention,
- La figure 6, un exemple de système de réflectométrie apte à mettre en œuvre le procédé selon l'invention.

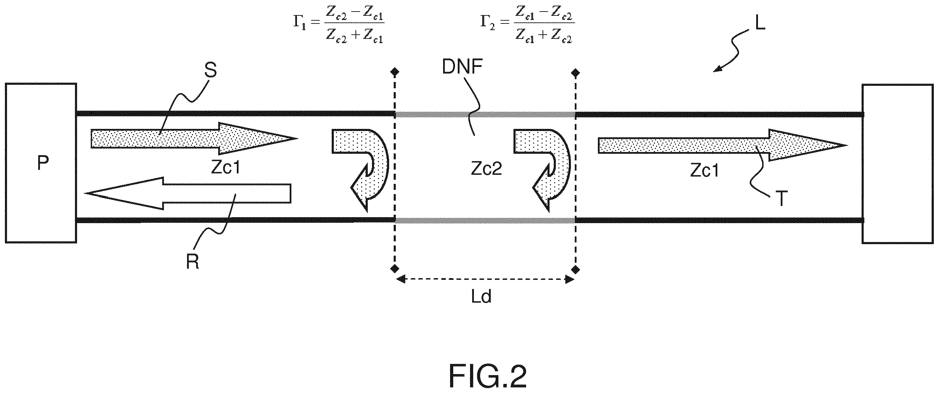

La figure 2 schématise, pour rappel, le principe de fonctionnement d'une méthode de diagnostic par réflectométrie appliquée à une ligne de transmission L présentant un défaut non-franc DNF. L'exemple décrit ci dessous correspond à une méthode de réflectométrie temporelle.

Un signal de référence S est injecté dans la ligne de transmission en un point P. Le signal réfléchi R est mesuré au même point P (ou en un autre point de la ligne). Ce signal se propage dans la ligne et rencontre, au cours de sa propagation, une première discontinuité d'impédance à l'entrée du défaut non franc DNF. Le signal se réfléchit sur cette discontinuité avec un coefficient de réflexion $\Gamma_1$. Si l'impédance caractéristique $Z_{c2}$ dans la zone du défaut non franc DNF est inférieure à l'impédance caractéristique $Z_{c1}$ avant l'apparition du défaut, alors le coefficient de réflexion $\Gamma_1$ est négatif et se traduit par un pic d'amplitude négative dans le signal réfléchi R. Dans le cas inverse, le coefficient de

réflexion $\Gamma_1$ est positif et se traduit par un pic d'amplitude positive dans le signal réfléchi R.

La partie transmise T du signal incident S continue de se propager dans la ligne et rencontre ensuite une deuxième discontinuité d'impédance créant une deuxième réflexion du signal incident avec un coefficient de réflexion $\Gamma_2$ de signe opposé au premier coefficient de réflexion $\Gamma_1$. Si $\Gamma_1 < 0$ alors $\Gamma_2 > 0$. Si $\Gamma_1 > 0$ alors $\Gamma_2 < 0$.

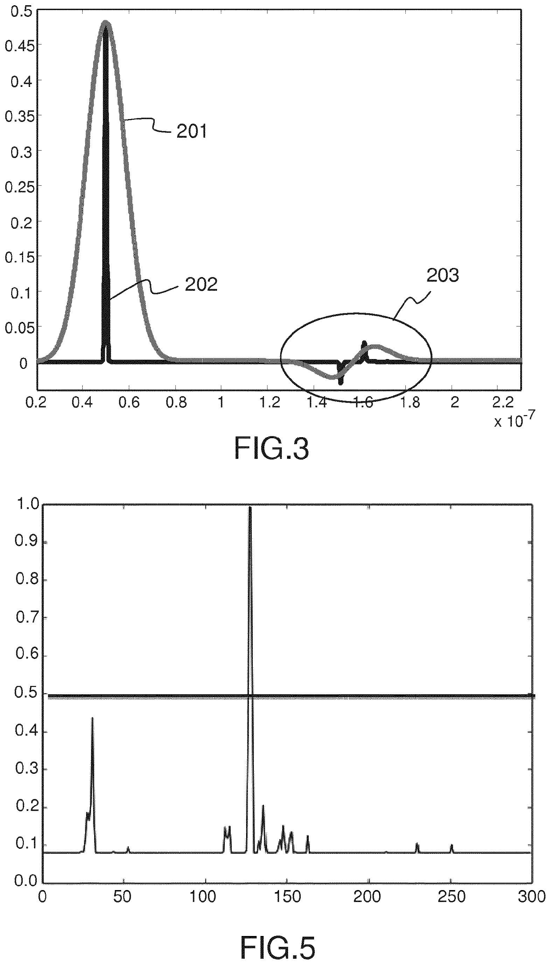

Ainsi, en observant le signal réfléchi R, la signature du défaut non franc DNF est caractérisée par deux pics successifs de signes inversés comme le montre la figure 3.

La figure 3 représente un réflectogramme temporel qui correspond soit directement à la mesure du signal réfléchi R, soit à l'intercorrélation entre le signal réfléchi R et le signal injecté dans le câble S.

Dans le cas où le signal de référence injecté est une impulsion temporelle, ce qui correspond au cas d'une méthode de réflectométrie temporelle, le réflectogramme peut correspondre directement à la mesure du signal réfléchi R. Dans le cas où le signal de référence injecté est un signal plus complexe, par exemple pour des méthodes de type MCTDR ou OMTDR, alors le réflectogramme est obtenu en inter-corrélant le signal réfléchi R et le signal injecté S.

Sur la figure 3, on a représenté deux réflectogrammes 201,202 correspondants à deux durées d'impulsion différentes pour le signal injecté dans le câble. La courbe 201 correspond à une durée d'impulsion $2.\Delta T$ très supérieure au temps de traversée, par le signal, du défaut non franc DNF. La longueur du défaut étant notée Ld, cette durée vaut Ld/V, avec V la vitesse de propagation du signal dans le câble. La courbe 202 correspond à une durée d'impulsion $2.\Delta T$ très inférieure au temps de traversée, par le signal, du défaut non franc DNF.

Dans les deux cas, la signature 203 du défaut non franc, dans le réflectogramme, est toujours composée de la succession d'un premier pic et d'un second pic dont les signes sont inversés.

La distance entre les deux pics représente la longueur du défaut non franc et leur amplitude représente la sévérité du défaut non franc. En effet, plus la variation de l'impédance caractéristique est importante, plus l'amplitude de la signature du défaut non franc dans le réflectogramme est également importante.

Comme cela est connu dans le domaine des méthodes de diagnostic par réflectométrie, la position $d_{DNF}$ du défaut non franc sur le câble, autrement dit sa distance au point P d'injection du signal, peut être directement obtenue à partir de la mesure, sur le réflectogramme temporel de la figure 3, de la durée $t_{DNF}$ entre le premier pic d'amplitude relevé sur le réflectogramme (à l'abscisse 0,5 sur l'exemple de la figure 3) et le pic d'amplitude 203 correspondant à la signature du défaut non franc.

Différentes méthodes connues sont envisageables pour déterminer la position $d_{DNF}$. Une première méthode consiste à appliquer la relation liant distance et temps : $d_{DNF} = V.t_{DNF}$ où V est la vitesse de propagation du signal dans le câble. Une autre méthode possible consiste à appliquer une relation de proportionnalité du type $d_{DNF}/ t_{DNF} = L/t_0$ où L est la longueur du câble et $t_0$ est la durée, mesurée sur le réflectogramme, entre le pic d'amplitude correspondant à la discontinuité d'impédance au point d'injection et le pic d'amplitude correspondant à la réflexion du signal sur l'extrémité du câble.

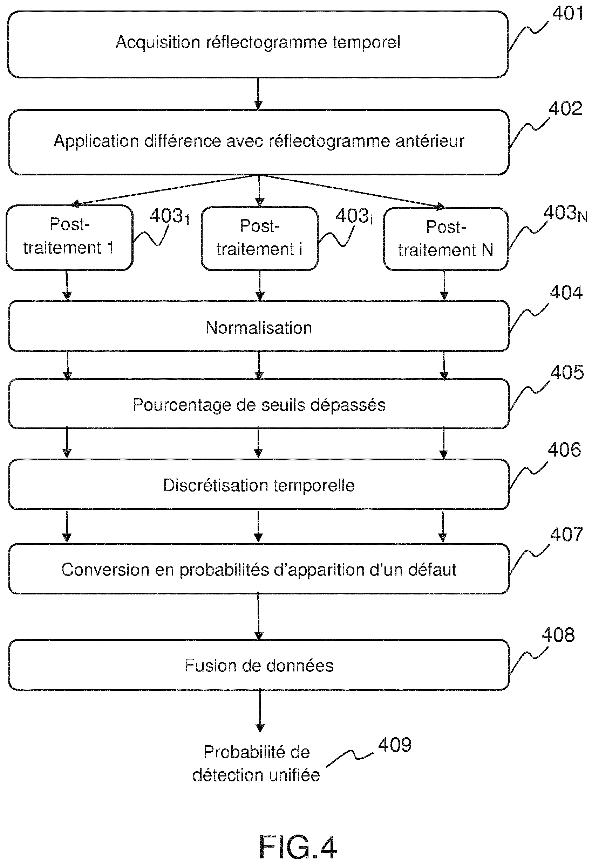

La figure 4 schématise sur un organigramme, les étapes de mise en œuvre du procédé de détection de défauts non francs selon l'invention.

Le procédé selon l'invention est appliqué à un réflectogramme temporel qui traduit les réflexions d'un signal de référence injecté dans le câble, sur les discontinuités d'impédance qu'il rencontre lors de sa propagation. La nature du réflectogramme dépend du type de signal de référence envisagé. De façon générale, quelle que soit la forme du signal, le réflectogramme peut être obtenu à partir d'une mesure du signal rétro-propagé dans le câble puis d'une inter-corrélation de cette mesure avec le signal de référence qui a été injecté dans le câble. Dans le cas où le signal de référence utilisé est une impulsion temporelle, par exemple une impulsion de forme Gaussienne, l'étape d'inter-corrélation de la mesure avec le signal de référence n'est pas nécessaire.

Ainsi, le procédé débute par l'acquisition ou la construction 401 d'un réflectogramme temporel à partir d'au moins une mesure d'un signal rétro-propagé dans le câble.

Dans une étape suivante 402, on détermine la différence entre le réflectogramme temporel obtenu à l'étape précédente 401 et un second réflectogramme temporel obtenu antérieurement. Le second réflectogramme peut être obtenu à partir d'une mesure faite au moment de l'installation du câble ou à tout moment antérieur à l'application du procédé selon l'invention.

L'application de la différence 402 permet d'obtenir un réflectogramme corrigé dans lequel les pics d'amplitude liés à certaines inhomogénéités existant nativement dans le câble sont éliminés du réflectogramme. Autrement dit, l'étape 402 permet d'évacuer les défauts permanents du câble qui ne correspondent pas à des défauts apparaissant après l'installation du câble et qui sont dus à des dégradations.

Alternativement, le second réflectogramme peut aussi être mesuré sur un câble distinct qui présente les mêmes caractéristiques physiques (type de câble, impédance, longueur ou paramètres RLCG) que le câble à tester, la mesure sur ce câble distinct étant réalisée au début de la vie du câble permettant ainsi de garantir l'absence de défauts sur ce câble.

La différence entre le réflectogramme courant et un réflectogramme obtenu antérieurement, permet également d'effectuer un suivi de l'évolution des défauts impactant le câble au cours du temps.

On applique ensuite au réflectogramme corrigé obtenu après l'étape 402, plusieurs méthodes de post-traitements $403_1, 403_i, 403_N$ ayant pour but de modifier le réflectogramme afin d'amplifier ou d'isoler les signatures des défauts non francs. Les méthodes de post-traitements mises en œuvre sont indépendantes entre elles. Autrement dit, chaque méthode applique un traitement algorithmique différent et non corrélé avec les autres traitements.

On donne ici une liste non exhaustive des méthodes de post-traitements compatibles de l'invention, cette liste pouvant être étendue à toute autre méthode alternative et indépendante des méthodes citées.

La demande de brevet français déposée sous le numéro FR1159481 propose une méthode qui consiste à appliquer au réflectogramme une transformée temps-fréquence particulière, basée sur la transformée de Wigner-Ville. L'application de cette transformée permet d'amplifier la signature des défauts non francs.

La demande de brevet français déposée sous le numéro FR1355377 propose une autre méthode qui consiste à estimer dans le domaine fréquentiel, à partir du réflectogramme, un paramètre caractéristique de la propagation d'un signal se propageant dans le câble, parmi lesquels l'atténuation a(f), le facteur de phase $\beta$(f) ou le coefficient de réflexion $\Gamma_{in}$(f), puis à transposer cette estimée dans le domaine temporel. Cette méthode permet également d'amplifier la signature des défauts non francs.

La demande de brevet français déposée sous le numéro FR1459402 propose une autre méthode basée sur un calcul d'inter-corrélation entre la mesure du signal réfléchi et le signal de référence injecté dans le câble. L'inter-corrélation est ensuite normalisée par un facteur dépendant de l'énergie du signal réfléchi, ce qui permet d'amplifier les signatures corrélées avec le signal d'injection avec un gain plus élevé pour les signatures d'amplitude faible qui sont représentatives de défauts non francs.

La demande de brevet français déposée sous le numéro FR1554632 propose une autre méthode consistant à identifier, dans le réflectogramme, les passages à zéro, puis à construire un réflectogramme modifié dans lequel l'amplitude des signatures des défauts non francs est amplifiée. Le réflectogramme modifié est déterminé à l'aide de la relation $z(t_0+t) = r(t_0+t)-r(t_0-t)$, où $t_0$ est l'abscisse d'un passage à zéro.

La demande de brevet français déposée sous le numéro FR1651702 propose encore une autre méthode qui est basée sur l'intégrale du réflectogramme.

Les publications [1] et [2] proposent encore d'autres méthodes de post-traitement.

Toutes les méthodes précitées présentent le point commun de mettre en œuvre une transformation particulière du réflectogramme dans le but d'amplifier les signatures des défauts non francs.

Un inconvénient de ces méthodes est qu'elles peuvent engendrer des fausses détections car elles peuvent également amplifier des artefacts liés à des inhomogénéités qui ne sont pas des défauts apparus après l'installation du câble.

Les étapes $403_1, 403_i, 403_N$ du procédé selon l'invention consistent donc à appliquer au réflectogramme plusieurs transformées particulières indépendantes entre elles.

Les étapes suivantes 404 à 407 du procédé sont exécutées pour chaque réflectogramme transformé obtenu par application des différentes méthodes de post-traitement. Toutes les méthodes sont indépendantes entre elles, c'est-à-dire qu'elles ne mettent pas en œuvre des transformations corrélées entre elles.

Une étape de fenêtrage (non représentée à la figure 4) peut être appliquée à chaque réflectogramme transformé afin de limiter la zone de traitement du réflectogramme à une zone dans laquelle des défauts non francs sont susceptibles d'apparaitre.

En particulier, l'application d'une étape de fenêtrage permet d'éliminer, dans le réflectogramme transformé, les pics d'amplitude dus à la désadaptation à l'entrée et à la sortie du câble pouvant entraîner une ambiguïté dans la détection et la localisation d'un défaut non franc. La désadaptation à l'entrée du câble est due généralement à un problème de couplage entre l'appareil de mesure (analyseur du réseau, générateur d'onde arbitraire et oscilloscope) et le câble sous test. Par exemple, effectuer une mesure sur des paires torsadées d'impédance caractéristique égale à 100 $\Omega$ avec un analyseur de réseau d'impédance caractéristique égale à 50 $\Omega$ entraîne une désadaptation à l'entrée du câble. Des artéfacts sont ainsi présents au début du réflectogramme créant une zone aveugle pour la détection et la localisation du défaut non franc. Le nombre d'échantillons du réflectogramme à traiter est ainsi réduit selon la largeur de la fenêtre sélectionnée.

Alternativement, l'étape de fenêtrage peut être mise en œuvre juste après l'acquisition du réflectogramme 401 ou être intégrée dans les étapes de post-traitement $403_1, 403_i, 403_N$.

Les méthodes de post-traitement $403_1, 403_i, 403_N$ appliquées sont par nature hétérogènes. Un objectif de l'invention est d'adapter les résultats fournis par ces différentes méthodes pour les rendre homogènes en vue de leur appliquer une étape de fusion de données 408. En d'autres termes, les réflectogrammes transformés par l'application des méthodes de post-traitement $403_1, 403_i, 403_N$, sont convertis en une mesure de la probabilité d'occurrence d'un défaut, avant d'être fusionnées (étape 408) pour produire une mesure unifiée de la probabilité d'occurrence d'un défaut. Les étapes 404,405,406,407 décrivent un exemple de réalisation de cette fonction de conversion.

Dans une étape 404, on unifie les différents réflectogrammes transformés en leur appliquant une étape de normalisation.

La normalisation est, par exemple, réalisée par rapport à la valeur maximale des valeurs absolues des échantillons d'un réflectogramme tel qu'explicité par la relation (1) :

$$y_{norm}(i) = \frac{y(i)}{|y|_{max}}, \qquad\qquad (1)$$

où i est l'indice temporel d'un échantillon du réflectogramme, y(i) est l'amplitude de l'échantillon d'indice i et $|y|_{max}$ est l'amplitude maximale en valeur absolue sur l'ensemble des échantillons d'un réflectogramme.

Sans sortir du cadre de l'invention, d'autres fonctions de normalisation peuvent être appliquées, par exemple une normalisation par rapport à la moyenne des valeurs absolues des échantillons ou toute autre valeur dérivée de la moyenne ou de l'amplitude maximale en valeur absolue.

Dans une étape 405, on détermine un seuil de détection dynamique s(n) qui peut être formulé via la relation suivante :

$$s(n) = s_0 + n\,p, \forall\, n \in [0, N] \qquad\qquad (2)$$

$S_0$ est la valeur initiale du seuil qui est choisie pour être supérieure au niveau moyen du bruit, p est un pas d'amplitude entre deux valeurs successives du seuil s(n), N est le nombre de valeurs du seuil dynamique s(n). Alternativement, on peut fixer N seuils distincts ayant des valeurs progressives comprises entre un seuil minimal $s_0$ et un seuil maximal $s_{max}$. L'incrément entre deux seuils consécutifs peut être constant ou variable. Les valeurs des seuils sont notamment configurées en fonction de la connaissance a priori des valeurs moyennes des pics d'amplitude associés aux signatures de défauts non francs que l'utilisateur souhaite détecter.

L'étape 405 consiste alors à convertir chaque réflectogramme normalisé obtenu à l'issue de l'étape 404 en un signal représentant, pour chaque échantillon, le pourcentage de seuils dépassés par cet échantillon.

Dans une étape 406, on applique ensuite, à chaque signal obtenu à l'étape 405, une discrétisation temporelle. Autrement dit, un signal obtenu à l'étape 405 est discrétisé en regroupant les échantillons du signal par intervalles temporels. Cette étape est nécessaire afin d'homogénéiser les résultats issus de l'application de différentes méthodes de post-traitement. En effet, en fonction de la transformation appliquée au réflectogramme, le pic d'amplitude correspondant à un défaut non franc peut subir un léger décalage temporel. Dans l'optique finale de procéder à une fusion des données issues des différentes méthodes, l'étape 406 permet d'unifier les résultats en raisonnant par intervalles temporels afin d'absorber les décalages temporels légers pouvant exister entre les résultats issus de différentes méthodes de post-traitement.

Les largeurs des intervalles peuvent être identiques entre elles ou non. Chaque intervalle temporel correspond, dans le domaine spatial, à un tronçon du câble analysé.

Les contraintes à respecter pour la discrétisation d'un signal sont doubles. La discrétisation doit correspondre à une partition complète, c'est-à-dire que deux intervalles temporels distincts ne doivent pas se recouvrir. En outre, tous les échantillons du signal doivent appartenir à un intervalle temporel. Le nombre d'intervalles doit être fini.

Les largeurs des intervalles peuvent être variables pour permettre une résolution de la représentation adaptée à la conduite d'un diagnostic filaire en augmentant le nombre d'intervalles dans les zones temporelles correspondant à des tronçons du câble qui sont susceptibles de constituer des zones présentant des défauts non francs.

La taille minimale de chaque intervalle temporel dépend directement de la sensibilité des méthodes d'analyse, et en particulier de la longueur d'onde du signal utilisé pour la construction des réflectogrammes.

Une fois les intervalles temporels définis, un signal discrétisé est obtenu en sommant les valeurs des échantillons du signal non discrétisé qui appartiennent au même intervalle.

Dans une étape 407, les différents signaux discrétisés sont ensuite convertis chacun en une mesure de la probabilité d'occurrence d'un défaut en une position du câble correspondant à un indice temporel du réflectogramme.

L'objectif de cette étape 407 est de produire une représentation unifiant des différents résultats obtenus à l'étape 406 afin de permettre leur agrégation ultérieure à l'étape 408 pour réaliser une fusion des différentes informations.

Plus précisément, l'étape 407 consiste à convertir les signaux discrétisés de l'étape 406 en probabilité d'apparition d'un défaut par tronçon de câble, un tronçon correspondant à un intervalle temporel en abscisse des signaux discrétisés. Cette probabilité est notée par la suite $P(D/m)$ avec m un indice permettant d'identifier la méthode de post traitement utilisée parmi les méthodes appliquées aux étapes $403_1, 403_i, 403_N$.

On introduit pour cela les définitions et les hypothèses suivantes. Chaque tronçon $t_i$ du câble à analyser est soumis à une expérience aléatoire binaire $E(t_i)$ : « Etat du tronçon de câble $t_i$ ». Les issues possibles de cette expérience aléatoire sont :

- $D_i$ : le tronçon $t_i$ comporte un défaut non franc
- $S_i = \bar{D}_1$ : le tronçon $t_i$ est sain (il ne comporte aucun défaut)

On détermine alors une mesure de la probabilité $P(D_i/m)$ de l'événement $D_i$ , de sorte que des probabilités proches de 1 indiqueront de façon quasi certaine la présence d'un défaut non-franc, alors que des probabilités proches de 0 indiqueront l'absence quasi certaine de défaut. Les valeurs de probabilités peuvent évoluer de façon continue dans l'intervalle [0 ;1] permettant ainsi de représenter la présence d'un défaut non franc avec un niveau de confiance précis et progressif.

Une valeur remarquable de la probabilité est la valeur $P(D_i|m)$ = 0.5. Cette valeur encode l'information selon laquelle les deux états du tronçon (défectueux et sain) sont équiprobables. En d'autres termes, si un tronçon $t_i$ présente cette valeur de probabilité, il n'est pas possible de se forger une opinion tranchée dans un sens ou dans l'autre. Cette probabilité encode ainsi le manque d'information fiable sur le tronçon $t_i$.

On suppose que l'expérience aléatoire pour chaque tronçon est indépendante de celles des autres tronçons.

On propose alors de construire la probabilité $P(D_i/m)$ de l'événement $D_i$ à partir des signaux discrétisés de l'étape 406 de la façon suivante.

Les valeurs des échantillons des signaux discrétisés obtenus à l'issue de l'étape 406 sont comprises entre deux valeurs réelles positives 0 et SMAX, SMAX variant en fonction des méthodes de post-traitement.

Pour convertir un signal discrétisé S en probabilité d'apparition d'un défaut sur le tronçon $t_i$, on utilise une fonction de mise en correspondance $f_m$ définie de la façon suivante :

$$f_m : [0; SMAX] \quad \rightarrow \quad [0; 1]$$
$$S(t_i) \quad \rightarrow \quad P(D_i|m)$$

La fonction de mise en correspondance $f_m$ doit être strictement croissante. Le choix de la fonction peut être adapté à chaque méthode de post-traitement afin de permettre l'interprétation probabiliste la plus pertinente possible.

Un exemple de fonction possible est donné par la relation (3).

$$P(D_i|m) = f_m\big(S(t_i)\big) = P_{min} + \frac{P_{max} - P_{min}}{S_{max}} \cdot S(t_i) \quad (3)$$

Il s'agit d'une fonction affine transformant l'intervalle [0 ; Smax] en l'intervalle [Pmin ; Pmax] avec Pmin et Pmax des paramètres vérifiant 0<Pmin<Pmax<1.

Pmin est la valeur minimale de la probabilité d'apparition d'un défaut ainsi construite. Pmax est sa valeur maximale. Les valeurs de ces deux paramètres sont notamment déterminées par rapport à la confiance relative que l'on souhaite associer aux résultats de chaque méthode de post-traitement. Une valeur proche de 0 choisie pour Pmin indique une confiance très élevée qu'un pic d'amplitude très faible ne correspond pas à un défaut. Une valeur proche de 1 choisie pour Pmax indique une confiance très élevée qu'un pic d'amplitude très élevée correspond à un défaut.

Ainsi, les paramètres Pmin et Pmax peuvent être différents pour chaque méthode de post-traitement et donc pour chaque signal discrétisé en entrée de l'étape 407.

Le choix des paramètres Pmin et Pmax peut aussi faire l'objet d'une phase de calibration préalable. Le choix de Pmin peut en particulier être guidé par l'étape initiale de prise de mesure sur un câble sain au moment de son installation. En fonction de la qualité de la mesure de référence (bruit de fond, inhomogénéité détectées dans le câble), une valeur de Pmin plus ou moins haute pourra être choisie. En particulier pour les câbles où le bruit de fond est très élevé, on pourra approcher Pmin de la valeur 0.5.

La valeur de Pmax peut être ajustée en fonction de la capacité de la méthode de post-traitement à ne pas engendrer de faux positifs. Plus la méthode est susceptible de produire un faux positif, moins la valeur de Pmax doit être haute.

Dans une étape finale 408, on opère une fusion des probabilités d'apparition de défauts produites par l'étape 407. Pour cela, on applique une fonction de fusion de données ou fusion d'information.

L'interprétation des résultats des méthodes de post-traitement sous la forme de probabilités d'apparition de défaut par tronçon telles que fournies par l'étape 407, permet de bénéficier de tous les travaux théoriques effectués dans le domaine de la fusion probabiliste de l'information. Ces travaux étant notamment décrits dans les références [3] et [4].

Une hypothèse du procédé selon l'invention est que les différentes méthodes de post-traitement $403_1, 403_i, 403_N$ sont exécutées séquentiellement sur le câble, et que l'effet d'une mesure n'impacte pas une mesure ultérieure. En

notant $P_x = P(D|m_x)$, où D est l'événement « apparition d'un défaut sur un tronçon » et $m_x$ identifie une méthode de post-traitement, cela signifie formellement que les probabilités Px et Py sont indépendantes dès que $x \neq y$. Par ailleurs, si on ne dispose d'aucune connaissance à priori sur le câble ni aucune mesure, on suppose que $P(D_i) = P(\bar{D}_1) = 0.5$.

Dans ces conditions on peut montrer que le résultat de la fusion de l'information issue de deux méthodes de post-traitement $m_1$ et $m_2$ peut être calculé à l'aide de la formule suivante :

$$P(D|m_1, m_2) = \frac{P_1 P_2}{P_1 P_2 + (1 - P_1)(1 - P_2)} \qquad (4)$$

Cette fonction de fusion peut ensuite être itérativement appelée pour fusionner les résultats d'un nombre quelconque de méthodes indépendantes. Autrement dit, si N méthodes de post-traitement sont appelées aux étapes $403_1, 403_i, 403_N$, alors on applique la fonction (4) aux résultats de l'étape 407 pris deux par deux. Puis, on itère le procédé en appliquant à nouveau la fonction (4) aux résultats de l'itération précédente pris deux par deux et ainsi de suite jusqu'à obtenir une unique probabilité d'apparition d'un défaut 409.

La fonction de fusion donnée par la relation (4) dispose de plusieurs propriétés intéressantes. Premièrement, la fusion de P avec 0.5 donne P : l'absence d'information ne modifie pas l'estimation courante de la présence d'un défaut. Deuxièmement, elle permet de renforcer les avis convergents. Ainsi, si P1 et P2 sont tous les deux supérieurs à 0.5, le résultat de la fusion sera lui aussi supérieur à 0.5 et même supérieur à P1 et P2.

Toute autre fonction de fusion d'informations issues des travaux de la fusion probabiliste de l'information peut être utilisée à la place de la fonction (4). En particulier, il est aussi possible d'utiliser une fonction dont le nombre d'opérandes est supérieur à deux voire, d'utiliser une fonction unique pour fusionner les N résultats sans nécessiter de réaliser un processus itératif.

La figure 5 présente un exemple de résultat obtenu à l'issue de l'étape 408. La courbe de probabilité représentée à la figure 5 peut être utilisée tel quelle pour identifier la présence d'un défaut en observant les pics de probabilité sur la courbe. Elle peut également être associée à une étape de diagnostic automatisé qui consiste à comparer les valeurs de la courbe de probabilité à un seuil de détection, par exemple fixé à la valeur 0.5. Les valeurs de probabilité supérieures à 0.5 traduisent une plus grande vraisemblance de l'existence d'un défaut.

Un avantage important de la méthode selon l'invention par rapport aux méthodes de l'art antérieur est qu'elle permet de diminuer le taux de fausses détections grâce à l'application d'une fusion de données appliquée à des résultats issus de différents traitements indépendants appliqués à un même réflectogramme.

Le procédé selon l'invention peut être mis en œuvre en tant que programme d'ordinateur, le procédé étant appliqué à une mesure de réflectométrie r préalablement acquise à l'aide d'un dispositif de réflectométrie usuel. L'invention peut être mise en œuvre en tant que programme d'ordinateur comportant des instructions pour son exécution. Le programme d'ordinateur peut être enregistré sur un support d'enregistrement lisible par un processeur.

La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro logiciel, un microcode, ou toute autre forme d'instruction d'ordinateur) qui peut être utilisé pour programmer un ou plusieurs processeurs pour mettre en œuvre des aspects des techniques décrites ici. Les moyens ou ressources informatiques peuvent notamment être distribués ("*Cloud computing"),* éventuellement selon des technologies de pair-à-pair. Le code logiciel peut être exécuté sur n'importe quel processeur approprié (par exemple, un microprocesseur) ou cœur de processeur ou un ensemble de processeurs, qu'ils soient prévus dans un dispositif de calcul unique ou répartis entre plusieurs dispositifs de calcul (par exemple tels qu'éventuellement accessibles dans l'environnement du dispositif). Le code exécutable de chaque programme permettant au dispositif programmable de mettre en œuvre les processus selon l'invention, peut être stocké, par exemple, dans le disque dur ou en mémoire morte. De manière générale, le ou les programmes pourront être chargés dans un des moyens de stockage du dispositif avant d'être exécutés. L'unité centrale peut commander et diriger l'exécution des instructions ou portions de code logiciel du ou des programmes selon l'invention, instructions qui sont stockées dans le disque dur ou dans la mémoire morte ou bien dans les autres éléments de stockage précités.

Alternativement, l'invention peut aussi être mise en œuvre au moyen d'un processeur embarqué dans un dispositif de test spécifique. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gate Array »). Le dispositif selon l'invention peut utiliser un ou plusieurs circuits électroniques dédiés ou un circuit à usage général. La technique de l'invention peut se réaliser sur une machine de calcul reprogrammable (un processeur ou un micro contrôleur par exemple) exécutant un programme comprenant une séquence d'instructions, ou sur une machine de calcul dédiée (par exemple un ensemble de portes logiques comme un FPGA ou un ASIC, ou tout autre module matériel).

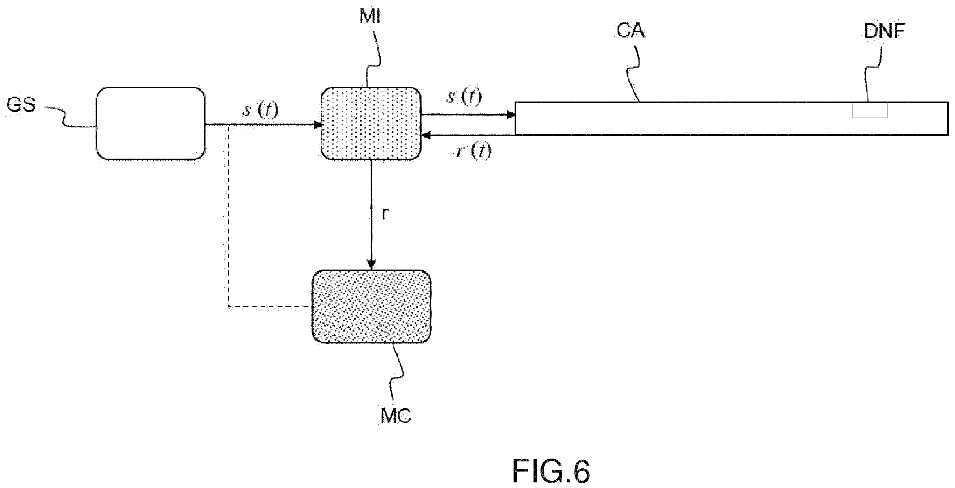

La figure 6 schématise, sur un synoptique, un exemple de système de réflectométrie apte à mettre en œuvre le procédé selon l'invention.

Un système de réflectométrie, ou réflectomètre, comporte au moins un générateur de signal GS, pour générer un signal de test s et l'injecter dans le câble à analyser CA qui comporte un défaut non franc DNF, un équipement de mesure MI pour mesurer le signal réfléchi r dans le câble CA et un composant électronique MC de type circuit intégré, tel un circuit à logique programmable, par exemple de type FPGA ou un micro-contrôleur, par exemple un processeur de signal numérique, qui reçoit la mesure du signal réfléchi r(t) et est configuré pour exécuter le procédé selon l'invention afin de détecter et localiser un ou plusieurs défauts non francs. Le composant électronique MC peut également comporter à la fois un circuit intégré, par exemple pour réaliser l'acquisition du signal réfléchi, et un micro-contrôleur pour exécuter les étapes de traitement requises par l'invention.

L'injection du signal de test s dans le câble peut être réalisée par un dispositif de couplage (non représenté à la figure 6) qui peut être un coupleur à effet capacitif ou inductif ou encore à l'aide d'une connexion ohmique. Le dispositif de couplage peut être réalisé par des connecteurs physiques qui relient le générateur de signal au câble ou par des moyens sans contact, par exemple en utilisant un cylindre métallique dont le diamètre interne est sensiblement égal au diamètre externe du câble et qui produit un effet de couplage capacitif avec le câble.

L'acquisition du signal réfléchi dans le câble peut également être réalisée au moyen d'un dispositif de couplage du type décrit précédemment.

Le système de réflectométrie peut également comporter un convertisseur numérique-analogique disposé entre le générateur de signal de test, dans le cas où il s'agit d'un signal numérique, et le coupleur d'injection.

Le système de réflectométrie peut également comporter un convertisseur analogique-numérique disposé entre le coupleur de mesure du signal réfléchi et l'équipement de mesure MI ou le composant électronique MC aux fins de numériser le signal analogique mesuré.

En outre, une unité de traitement (non représentée à la figure 6), de type ordinateur, assistant numérique personnel ou autre est utilisée pour piloter le système de réflectométrie selon l'invention et afficher les résultats des mesures sur une interface homme-machine.

Les résultats affichés peuvent comprendre un ou plusieurs réflectogrammes calculés à l'aide du procédé selon l'invention et/ou une information relative à l'existence et à la localisation d'un défaut sur le câble également produite par le procédé selon l'invention.

Selon un mode de réalisation particulier, le signal de test s injecté peut également être fourni au composant MC lorsque les traitements réalisés nécessitent la connaissance du signal injecté, notamment lorsque ceux-ci incluent une étape d'intercorrélation entre le signal de test s et le signal réfléchi r.

L'injection du signal dans le câble et la mesure du signal réfléchi peuvent être réalisées par un seul et même composant mais aussi par deux composants distincts, notamment lorsque le point d'injection et le point de mesure sont dissociés.

Le système décrit à la figure 6 peut être mis en œuvre par une carte électronique sur laquelle sont disposés les différents composants. La carte peut être connectée au câble par un coupleur.

En outre, une unité de traitement, de type ordinateur, assistant numérique personnel ou autre dispositif électronique ou informatique équivalent peut être utilisé pour piloter le dispositif de réflectométrie et afficher les résultats des calculs effectués par le composant MC sur une interface homme-machine, en particulier les informations de détection et localisation de défauts sur le câble.

Références

[1] Y. J. Shin et al. « Joint Time-Frequency Domain Reflectometry for Diagnostics of Coaxial Cables » . In 8th Joint NASA/FAA/DoD Conférence on Aging Aircraft. 2005.

[2] Lola El Sahmarany. « Méthodes d'amélioration pour le diagnostic de câble par réflectométrie ». Université Biaise Pascal - Clermont-Ferrand II, 2013.

[3] H. Moravec, « Sensor fusion in certainty grids for mobile robots » in AI Mag. Vol. 9, July 1988

[4] J. Berger, « Statistical decision theory and Bayesian analysis » 2nd édition, Springer, 1985

**Revendications**

**1.** Procédé de détection de défauts non francs dans une ligne de transmission (L) comprenant les étapes suivantes :

- Acquérir (401) une mesure, appelée réflectogramme temporel, d'un signal (R) caractéristique de la réflexion d'un signal de référence (S) préalablement injecté dans la ligne (L),
- Déterminer (402) la différence entre ledit réflectogramme temporel et un réflectogramme temporel mesuré antérieurement pour la même ligne (L) ou une autre ligne de caractéristiques similaires, afin d'obtenir un réflectogramme temporel corrigé,
- Appliquer ($403_1$, $403_i$, $403_N$) une pluralité de transformations indépendantes au réflectogramme temporel corrigé afin d'obtenir une pluralité de réflectogrammes transformés indépendants,
- Convertir (404,405,406,407) les réflectogrammes transformés en une pluralité de probabilités d'occurrence d'un défaut indépendantes entre elles,
- Appliquer (408) une méthode de fusion de données aux probabilités d'occurrence d'un défaut pour en déduire une valeur unifiée de la probabilité d'occurrence d'un défaut.

2.  Procédé de détection de défauts non francs selon la revendication 1 dans une ligne de transmission (L) dans lequel la conversion de chaque réflectogramme transformé en une mesure de la probabilité d'occurrence d'un défaut comprend les étapes suivantes :

- Normaliser (404) en amplitude chaque réflectogramme transformé,
- Définir (405) une pluralité de seuils de détection et pour chaque réflectogramme normalisé, construire (405) un signal représentant le pourcentage de seuils de détection dépassés par chaque échantillon,
- Discrétiser (406) temporellement chaque signal,
- Convertir (407) chaque signal discrétisé en une probabilité d'occurrence d'un défaut.

3.  Procédé de détection de défauts non francs selon la revendication 2 dans lequel la normalisation (404) en amplitude de chaque réflectogramme transformé est une normalisation par le maximum de la valeur absolue des échantillons du réflectogramme transformé.

4.  Procédé de détection de défauts non francs selon l'une des revendications 2 ou 3 dans lequel les seuils de détection sont définis (405) en choisissant un seuil initial $s_0$ de valeur au moins supérieure à un niveau de bruit moyen et chaque seuil successif égal au seuil précédent incrémenté d'un pas constant.

5.  Procédé de détection de défauts non francs selon l'une des revendications 2 à 4 dans lequel la discrétisation temporelle (406) de chaque signal comprend :

- la partition temporelle du signal en une pluralité d'intervalles temporels et,
- pour chaque intervalle temporel, la somme des nombres de seuils normalisés comptabilisés pour chaque échantillon appartenant audit intervalle temporel.

6.  Procédé de détection de défauts non francs selon l'une des revendications 2 à 5 dans lequel la conversion (407) de chaque signal discrétisé en une probabilité d'occurrence d'un défaut comprend l'application, à chaque signal discrétisé, d'une fonction de conversion affine.

7.  Procédé de détection de défauts non francs selon l'une des revendications précédentes dans lequel la méthode de fusion de données appliquée (408) comprend :

- Le regroupement des probabilités d'occurrence d'un défaut par couples,
- Une première application d'une fonction de fusion de données à chaque couple de probabilités,
- Une application itérative de la fonction de fusion de données aux résultats de la première application jusqu'à obtenir une unique valeur unifiée de probabilité d'occurrence d'un défaut.

8.  Procédé de détection de défauts non francs selon l'une des revendications précédentes comprenant en outre une étape de diagnostic comprenant la comparaison de la valeur unifiée de probabilité d'occurrence d'un défaut à un seuil de détection.

9.  Procédé de détection de défauts non francs selon l'une des revendications précédentes dans lequel l'acquisition (401) d'un réflectogramme temporel comprend la corrélation de la mesure du signal (R) caractéristique de la réflexion d'un signal de référence (S) préalablement injecté dans la ligne (L) et dudit signal de référence (S).

10. Programme d'ordinateur comportant des instructions pour l'exécution du procédé de détection de défauts non francs dans un câble selon l'une quelconque des revendications 1 à 9, lorsque le programme est exécuté par un processeur.

11. Support d'enregistrement lisible par un processeur sur lequel est enregistré un programme comportant des instructions pour l'exécution du procédé de détection de défauts non francs dans un câble selon l'une quelconque des revendications 1 à 9, lorsque le programme est exécuté par un processeur.

**Patentansprüche**

1. Verfahren zur Detektion von weichen Fehlern in einer Übertragungsleitung (L), umfassend die folgenden Schritte:

    - Erfassen (401) eines Maßes, das als zeitliches Reflektogramm bezeichnet wird, eines Signals (R), das für die Reflexion eines Referenzsignals (S), das zuvor in die Leitung (L) eingespeist wurde, charakteristisch ist,
    - Bestimmen (402) der Differenz zwischen dem zeitlichen Reflektogramm und einem zeitlichen Reflektogramm, das zuvor für die gleiche Leitung (L) oder eine andere Leitung mit ähnlichen Merkmalen gemessen wurde, um ein korrigiertes zeitliches Reflektogramm zu erhalten,
    - Anwenden ($403_1$, $403_i$, $403_N$) einer Vielzahl von unabhängigen Transformationen auf das korrigierte zeitliche Reflektogramm, um eine Vielzahl von unabhängigen transformierten Reflektogrammen zu erhalten,
    - Umwandeln (404, 405, 406, 407) der transformierten Reflektogramme in eine Vielzahl von voneinander unabhängigen Wahrscheinlichkeiten des Auftretens eines Fehlers,
    - Anwenden (408) eines Datenzusammenführungsverfahrens auf die Wahrscheinlichkeiten des Auftretens eines Fehlers, um daraus einen vereinheitlichten Wert der Wahrscheinlichkeit des Auftretens eines Fehlers herzuleiten.

2. Verfahren zur Detektion von weichen Fehlern nach Anspruch 1 in einer Übertragungsleitung (L), wobei die Umwandlung eines jeden transformierten Reflektogramms in ein Maß der Wahrscheinlichkeit des Auftretens eines Fehlers die folgenden Schritte umfasst:

    - Normalisieren (404) der Amplitude eines jeden transformierten Reflektogramms,
    - Definieren (405) einer Vielzahl von Detektionsschwellen und, für jedes normalisierte Reflektogramm, Generieren (405) eines Signals, das für den Prozentsatz der von jeder Abtastung überschrittenen Detektionsschwellen steht,
    - zeitliches Diskretisieren (406) eines jeden Signals,
    - Umwandeln (407) eines jeden diskretisierten Signals in eine Wahrscheinlichkeit des Auftretens eines Fehlers.

3. Verfahren zur Detektion von weichen Fehlern nach Anspruch 2, wobei die Normalisierung (404) der Amplitude eines jeden transformierten Reflektogramms eine Normalisierung durch das Maximum des absoluten Wertes der Abtastungen des transformierten Reflektogramms ist.

4. Verfahren zur Detektion von weichen Fehlern nach einem der Ansprüche 2 oder 3, wobei die Detektionsschwellen definiert (405) werden, indem eine Anfangsschwelle $s_0$ mit einem Wert, der mindestens größer als ein durchschnittlicher Geräuschpegel ist, und jede nachfolgende Schwelle gleich der vorhergehenden Schwelle, inkrementiert um einen konstanten Schritt, ausgewählt wird.

5. Verfahren zur Detektion von weichen Fehlern nach einem der Ansprüche 2 bis 4, wobei die zeitliche Diskretisierung (406) eines jeden Signals Folgendes umfasst:

    - die zeitliche Unterteilung des Signals in eine Vielzahl von Zeitschlitzen und
    - für jeden Zeitschlitz die Summe der Anzahl der normalisierten Schwellen, die für jede Abtastung, die zu dem Zeitschlitz gehört, gezählt wurde.

6. Verfahren zur Detektion von weichen Fehlern nach einem der Ansprüche 2 bis 5, wobei die Umwandlung (407) eines jeden diskretisierten Signals in eine Wahrscheinlichkeit des Auftretens eines Fehlers das Anwenden einer affinen Konverterfunktion auf jedes diskretisierte Signal umfasst.

7. Verfahren zur Detektion von weichen Fehlern nach einem der vorhergehenden Ansprüche, wobei das angewandte Datenzusammenführungsverfahren (408) Folgendes umfasst:

- das paarweise Gruppieren der Wahrscheinlichkeiten des Auftretens eines Fehlers,
- eine erste Anwendung einer Datenzusammenführungsfunktion auf jedes Paar von Wahrscheinlichkeiten,
- eine iterative Anwendung der Datenzusammenführungsfunktion auf die Ergebnisse der ersten Anwendung, bis ein eindeutiger vereinheitlichter Wert der Wahrscheinlichkeit des Auftretens eines Fehlers erhalten wird.

8. Verfahren zur Detektion von weichen Fehlern nach einem der vorhergehenden Ansprüche, ferner umfassend einen Diagnoseschritt, der den Vergleich des vereinheitlichten Wertes der Wahrscheinlichkeit des Auftretens eines Fehlers mit einer Detektionsschwelle umfasst.

9. Verfahren zur Detektion von weichen Fehlern nach einem der vorhergehenden Ansprüche, wobei die Erfassung (401) eines zeitlichen Reflektogramms die Korrelation des Maßes des Signals (R), das für die Reflexion eines Referenzsignals (S) charakteristisch ist, das zuvor in die Leitung (L) eingespeist wurde, und des Referenzsignals (S) umfasst.

10. Computerprogramm, umfassend Anweisungen zum Ausführen des Detektionsverfahrens für weiche Fehler in einem Kabel nach einem der Ansprüche 1 bis 9, wenn das Programm von einem Prozessor ausgeführt wird.

11. Speichermedium, das von einem Prozessor lesbar ist, auf dem ein Programm gespeichert ist, das Anweisungen zum Ausführen des Detektionsverfahrens für weiche Fehler in einem Kabel nach einem der Ansprüche 1 bis 9 umfasst, wenn das Programm von einem Prozessor ausgeführt wird.


**Claims**

1. A method for detecting soft faults in a transmission line (L) comprising the following steps:

   - acquiring (401) a measurement, called time-domain reflectogram, of a signal (R) characteristic of the reflection of a reference signal (S) previously injected into the line (L),
   - determining (402) the difference between said time-domain reflectogram and a time-domain reflectogram measured previously for the same line (L) or another line of similar characteristics, in order to obtain a corrected time-domain reflectogram,
   - applying ($403_1$, $403_i$, $403_N$) a plurality of independent transformations to the corrected time-domain reflectogram in order to obtain a plurality of independent transformed reflectograms,
   - converting (404, 405, 406, 407) the transformed reflectograms into a plurality of mutually independent probabilities of occurrence of a fault,
   - applying (408) a data merging method to the probabilities of occurrence of a fault to deduce therefrom a unified value of the probability of occurrence of a fault.

2. The method for detecting soft faults, according to claim 1, in a transmission line (L) wherein the conversion of each transformed reflectogram into a measurement of the probability of occurrence of a fault comprises the following steps:

   - normalising (404) in amplitude each transformed reflectogram,
   - defining (405) a plurality of detection thresholds and, for each normalised reflectogram, constructing (405) a signal representing the percentage of detection thresholds exceeded by each sample,
   - temporally discretising (406) each signal,
   - converting (407) each discretised signal into a probability of occurrence of a fault.

3. The method for detecting soft faults according to claim 2, wherein the normalisation (404) in amplitude of each transformed reflectogram is a normalisation by the maximum of the absolute value of the samples of the transformed reflectogram.

4. The method for detecting soft faults according to one of claims 2 or 3, wherein the detection thresholds are defined (405) by choosing an initial threshold $s_0$ of a value at least greater than an average level of noise and each successive threshold is chosen equal to the preceding threshold incremented by a constant pitch.

5. The method for detecting soft faults according to one of claims 2 to 4, wherein the temporal discretisation (406) of each signal comprises:

- the temporal division of the signal into a plurality of time intervals and,
- for each time interval, the sum of the numbers of normalised thresholds counted for each sample belonging to said time interval.

6. The method for detecting soft faults according to one of claims 2 to 5, wherein the conversion (407) of each discretised signal into a probability of occurrence of a fault comprises the application, to each discretised signal, of an affine conversion function.

7. The method for detecting soft faults according to one of the preceding claims, wherein the data merging method applied (408) comprises:

- the grouping of the probabilities of occurrence of a fault in pairs,
- a first application of a data merging function to each pair of probabilities,
- an iterative application of the data merging function to the results of the first application until a single unified value of probability of occurrence of a fault is obtained.

8. The method for detecting soft faults according to one of the preceding claims, further comprising a diagnostic step comprising the comparison of the unified value of probability of occurrence of a fault to a detection threshold.

9. The method for detecting soft faults according to one of the preceding claims, wherein the acquisition (401) of a time-domain reflectogram comprises the correlation of the measurement of the signal (R) characteristic of the reflection of a reference signal (S) previously injected into the line (L) and of said reference signal (S).

10. A computer program containing instructions for the execution of the method for detecting soft faults in a cable according to any one of claims 1 to 9, when the program is run by a processor.

11. A processor-readable storage medium on which is stored a program containing instructions for executing the method for detecting soft faults in a cable according to any one of claims 1 to 9, when the program is executed by a processor.

FIG.1

FIG.2

$$\Gamma_1 = \frac{Z_{c2} - Z_{c1}}{Z_{c2} + Z_{c1}}$$

$$\Gamma_2 = \frac{Z_{c1} - Z_{c2}}{Z_{c1} + Z_{c2}}$$

FIG.3

FIG.5

Acquisition réflectogramme temporel ⟋ 401

Application différence avec réflectogramme antérieur ⟋ 402

Post-traitement 1 ⟋ 403₁  Post-traitement i ⟋ 403ᵢ  Post-traitement N ⟋ 403ₙ

Normalisation ⟋ 404

Pourcentage de seuils dépassés ⟋ 405

Discrétisation temporelle ⟋ 406

Conversion en probabilités d'apparition d'un défaut ⟋ 407

Fusion de données ⟋ 408

Probabilité de détection unifiée ⟋ 409

FIG.4

FIG.6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1159481
- FR 1355377
- FR 1459402
- FR 1554632
- FR 1651702
- GB 2496121 A
- FR 2981752
- US 2005057880 A

**Littérature non-brevet citée dans la description**

- **Y. J. SHIN et al.** Joint Time-Frequency Domain Reflectometry for Diagnostics of Coaxial Cables. *In 8th Joint NASA/FAA/DoD Conférence on Aging Aircraft.,* 2005
- **LOLA EL SAHMARANY.** Méthodes d'amélioration pour le diagnostic de câble par réflectométrie. Université Biaise Pascal, 2013
- **H. MORAVEC.** Sensor fusion in certainty grids for mobile robots. *AI Mag.,* Juillet 1988, vol. 9
- **J. BERGER.** Statistical decision theory and Bayesian analysis. Springer, 1985